# EUROPEAN PATENT SPECIFICATION

(11) **EP 1 289 004 B1**
(45) Date of publication and mention of the grant of the patent: **15.03.2006**
(21) Application number: 02016868.8
(22) Date of filing: 30.07.2002
(51) Int. Cl.: H01L 21/318, H01L 21/321, H01L 23/532

(54) **Semiconductor device manufacturing method**
Verfahren zur Herstellung eines Halbleiterbauelements
Procédé de fabrication d'un dispositif semiconducteur

(30) Priority: 24.08.2001 JP 2001254533; 03.06.2002 JP 2002161874
(43) Date of publication of application: 05.03.2003
(73) Proprietor: CANON SALES CO., INC., Minato-ku, Tokyo 108-0073 (JP); SEMICONDUCTOR PROCESS LABORATORY CO., LTD., Minato-ku, Tokyo 108-0075 (JP)
(72) Inventor: Shioya, Yoshimi, Semiconductor Process Lab.Co. Ltd, Tokyo 108-0075 (JP); Nishimoto, Yuhko, Semiconductor Process Lab.Co.Ltd, Tokyo 108-0075 (JP); Suzuki, Tomomi, Minato-ku, Tokyo 108-0073 (JP); Ohgawara, Shoji, Minato-ku, Tokyo 108-0073 (JP); Maeda, Kazuo, Semiconductor Process Lab. Co. Ltd., Tokyo 108-0075 (JP)
(74) Representative: Schwabe - Sandmair - Marx

(56) References cited:
- US-A- 6 013 578
- US-A1- 2001 003 064
- PATENT ABSTRACTS OF JAPAN vol. 2000, no. 05, 14 September 2000 (2000-09-14) & JP 2000 058544 A (MATSUSHITA ELECTRON CORP), 25 February 2000 (2000-02-25)

## Description

### BACKGROUND OF THE INVENTION

### a) Field of the Invention

The present invention relates to a semiconductor device manufacturing method and, more particularly, the technology of preventing diffusion of Cu in a copper (Cu) wiring layer in connection with the multi-layered wiring technology.

### b) Description of the Prior Art

The LSI is manufactured by connecting the transistors, the diodes, the capacitors, the resistors, etc. arranged electrically separately on the semiconductor substrate via wirings.

The technology for connecting the elements at the high density is the multi-layered wiring technology, and this multi-layered wiring technology is the important technology for deciding the higher performance of LSI. The parasitic effects of the resistances, the capacitances, etc. in the multi-layered wiring have the large influence on the circuit performance of LSI. In light of such viewpoint, the multi- layered wiring in which the Cu (copper) wiring, which has the low resistance, and the interlayer insulating film, which is made of the material having the low dielectric constant, are used in combination is now employed. As this manufacturing method, the burying process, i.e., so-called damascene process, is now employed.

The Cu wiring layer has the characteristic such that Cu in the Cu wiring layer is ready to diffuse into the interlayer insulating film in the step in which the annealing is applied, or the like. If the Cu in the Cu wiring layer diffuses into the interlayer insulating film, disadvantages such that the leakage current in the interlayer insulating film is increased are brought about. For this reason, the diffusion of Cu in the Cu wiring layer is prevented by forming the Cu diffusion preventing insulating film such as the silicon nitride film, which has the Cu diffusion preventing function, between the Cu wiring layer and the interlayer insulating film.

However, the dielectric constant (e.g., ε=5 or so) of the insulating film that can prevent the diffusion of Cu is considerably higher than that (e.g., ε=2.8 or so) of the insulating film that has the low dielectric constant. Therefore, even if the major part of the interlayer insulating film is formed by the insulating film having the low dielectric constant, the parasitic capacitance between the Cu wiring layers in the multi-layered wiring is increased effectively because of the intervention of the Cu diffusion preventing insulating film. For instance, in the situation that a total film thickness of the interlayer insulating film is fixed to 500 nm, if 100 nm is assigned to a thickness of the Cu diffusion preventing insulating film (ε =5 or so) and a remaining thickness is assigned to the insulating film having the low dielectric constant (ε =2.8 or so), an effective dielectric constant of the interlayer insulating film is increased up to about 3.05. As a result, the delay in the electric signal that is propagated in the wiring of the multi-layered wiring in LSI, i.e., the wiring delay is increased, and it is possible that this delay causes the fatal problem.

Therefore, it is studied that the film thickness of the Cu diffusion preventing insulating film is reduced. However, because of the influence of the step of forming the Cu diffusion preventing insulating film on the Cu wiring layer by the plasma CVD method, the later step of executing the annealing at about 400 to 450 °C , etc . , Cu projections are readily generated from the surface layer portion of the Cu wiring layer. Thus, there is the problem that the Cu is diffused from this projection portion.

Further, in the prior art, it is difficult to use the insulating film having the low dielectric constant as the Cu diffusion preventing insulating film that can prevent the diffusion of Cu. As a result, a method of forming an insulating film that has the low dielectric constant and is able to prevent the diffusion of Cu is desired earnestly.

US 2001/0003064 Al discloses a method for fabricating a semiconductor device wherein an interconnect made of copper overlying a substrate is pretreated at a specified temperature, for example, at 300°Celsius or less. Further a dielectric film is formed on the copper at a temperature higher than that of the pretreatment.

US 6,013,578 discloses a metal wiring structure including a conduction line, an insulator film for electrically insulating the conduction line and a transmutation layer formed as the density of a portion of the insulator film adjacent to the conduction line is increased or by adding impurities to the insulator film.

### SUMMARY OF THE INVENTION

It is an object of the present invention to provide a semiconductor device manufacturing method capable of reducing a capacitance between wiring layers of the multi-layered wiring by preventing the generation of projections of a Cu wiring layer to reduce a film thickness of a Cu diffusion preventing insulating film and by making it possible to use an insulating film, a dielectric constant of which is low, as the Cu diffusion preventing insulating film.

The present invention provides a semiconductor device manufacturing method which comprises the steps of forming a silicon- containing insulating film on a wiring layer made mainly of a copper (Cu) formed over a semiconductor substrate; and exposing the silicon-containing insulating film to an atmosphere or a plasma of a hydrocarbon (CₓH_{y}) gas.

Therefore, a carbon-containing layer can be formed on the surface layer of the silicon-containing insulating film. The carbon-containing layer has the etching resistance against the gaseous or liquid etchant for the silicon- containing insulating film. As a result, not only the barrier function against the copper particles of the copper wiring layer but also the etching stopper function used when the thick interlayer insulating film formed on the barrier insulating film is etched can be provided to the silicon- containing insulating film by the simple process.

Also, the present invention provides a semiconductor device manufacturing method which comprises the steps of exposing a surface of a copper (Cu) wiring layer formed over a semiconductor substrate to a plasma of a gas selected from the group consisting of an ammonia gas, a mixed gas of nitrogen and hydrogen, a CF₄ gas, a C₂F₆ gas and a NF₃ gas; exposing the surface of the copper (Cu) wiring layer to an atmosphere or a plasma of a gas selected from the group consisting of an ammonia gas, an ethylenediamine gas, a beta-diketone gas, a mixed gas consisting of the ammonia gas and a hydrocarbon gas (CₓH_{y}), and ammonia gas and the hydrocarbon gas (CₓH_{y}), and the mixed gas consisting of the nitrogen gas and the hydrocarbon gas (CₓH_{y}).

If the surface of the Cu wiring layer is processed by the atmosphere or the plasma of the gas in the situation that the natural oxide film on the surface of the Cu wiring layer is removed in advance, a compound layer (or a bonding layer) in which the element such as N, H, C, or the like contained in these gases is combined with or bonded to Cu is formed on the surface layer portion of the Cu wiring layer. If the ethylenediamine gas, the β-diketone gas, the gas of the compound that is similar to them, or the like is employed, the complex is formed on the surface layer portion of the Cu wiring layer.

Then, the Cu diffusion preventing insulating film is formed on the Cu wiring layer that is subjected to the surface treatment. At this time, since the above compound layer is formed on the surface layer portion of the Cu wiring layer, the generation of projections from the surface layer portion of the Cu wiring layer in the step of forming the Cu diffusion preventing insulating film or the step of applying the annealing process later can be suppressed. Accordingly, even if a film thickness of the Cu diffusion preventing insulating film is reduced, the diffusion of Cu can be prevented.

In addition, the surface layer portion (compound layer) of the Cu wiring layer can also function as the Cu diffusion preventing film. Therefore, even if the insulating film whose dielectric constant is low but whose Cu diffusion preventing capability is not high is employed as the Cu diffusion preventing insulating film, the diffusion of Cu can be prevented.

As a result, since the increase in the capacitance between the Cu wiring layers can be prevented, the multi-layered wiring for the high-performance LSI having the small wiring delay can be manufactured.

Also, the present invention provides a semiconductor device manufacturing method which comprises the steps of exposing a surface of a copper (Cu) wiring layer formed over a semiconductor substrate to a plasma of an ammonia gas; forming a silicon-containing insulating film on the copper (Cu) wiring layer; and exposing the silicon-containing insulating film to an atmosphere or a plasma selected from the group consisting of an atmosphere or a plasma of a mixed gas consisting of an ammonia gas and a hydrocarbon gas (CₓH_{y}), an atmosphere or a plasma of a mixed gas consisting of a nitrogen gas and the hydrocarbon gas (CₓH_{y}) , a plasma of the nitrogen gas, and an atmosphere of the ammonia gas.

According to the present invention, first the natural oxide film on the surface of the Cu wiring layer is removed by exposing the surface of the Cu wiring layer to the plasma of the ammonia gas.

Then, the silicon-containing insulating film is formed on this Cu wiring layer. At this time, in order to reduce the parasitic capacitance around the Cu wiring, for example, the silicon-containing insulating film whose dielectric constant is relatively low is formed. In this case, the silicon-containing insulating film is still the insulating film whose Cu diffusion preventing capability is not high at this point of time.

Then, this Cu diffusion preventing insulating film is exposed to the atmosphere or the plasma of the above gas, for example, the mixed gas consisting of the ammonia gas and the hydrocarbon (CₓH_{y}) gas.

In this step, the process may be carried out by two following steps. More particularly, first the silicon-containing insulating film may be exposed to either the atmosphere or the plasma of the ammonia gas or the plasma of the nitrogen gas, and then such film may be exposed to the plasma of the CₓH_{y} gas. Otherwise, in the opposite sequence to the above two steps, first the silicon-containing insulating film may be exposed to the plasma of the hydrocarbon (CₓH_{y}) gas, and then such film may be exposed to either the atmosphere or the plasma of the ammonia gas or the plasma of the nitrogen gas.

In this manner, the film quality of the silicon-containing insulating film can be changed into the insulating film having the high Cu diffusion preventing capability by exposing the silicon-containing insulating film, whose dielectric constant is low but whose Cu diffusion preventing capability is not high, to the atmosphere or the plasma of the above gas. Accordingly, the insulating film whose dielectric constant is low can be employed as the Cu diffusion preventing insulating film that can prevent the diffusion of Cu. Therefore, since not only the diffusion of Cu in the Cu wiring layer can be prevented but also the increase in the parasitic capacitance around the Cu wiring layer can be prevented, the multi-layered wiring for the high-performance LSI having the small wiring delay can be manufactured.

In addition, since the natural oxide film on the surface layer portion of the Cu wiring layer is removed by the plasma of the ammonia gas and then the silicon-containing insulating film-is formed on the Cu wiring layer, the adhesiveness between the Cu wiring layer and the silicon- containing insulating film can be improved. Therefore, the reliability of the multi-layered wiring can be improved.

### BRIEF DESCRIPTION OF THE DRAWINGS

FIG.1 is a schematic sectional view showing the plasma CVD equipment employed in the semiconductor device manufacturing method according to embodiments of the present invention;
FIGS.2A and 2B are schematic sectional views showing a semiconductor device manufacturing method according to a first embodiment of the present invention;
FIG.3 is a graph showing a current (I)-voltage (V) characteristic of a reference sample prior to the annealing;
FIG.4 is a graph showing a current (I)-voltage (V) characteristic of the reference sample after the annealing;
FIG . 5 is a graph showing a current (I)-voltage (V) characteristic of a test sample (processed by an NH₃+C₇H₁₄ gas plasma) according to the first embodiment of the present invention prior to the annealing;
FIG.6 is a graph showing a current (I)-voltage (V) characteristic of the test sample (processed by the NH₃+C₇H₁₄ gas plasma) according to the first embodiment of the present invention after the annealing;
FIGS.7A and 7B are schematic sectional views showing a semiconductor device manufacturing method according to a second embodiment of the present invention;
FIG.8 is a graph showing a current (I)-voltage (V) characteristic of a test sample 1A (processed in an NH₃ gas atmosphere) according to the second embodiment of the present invention prior to the annealing not covered by the invention;
FIG.9 is a graph showing a current (I)-voltage (V) characteristic of the test sample 1A (processed in the NH₃ gas atmosphere) according to the second embodiment of the present invention after the annealing not covered by the invention;
FIG.10 is a graph showing a current (I)-voltage (V) characteristic of a test sample 2A (NH₃+CH₄ gas plasma process) according to the second embodiment of the present invention prior to the annealing;
FIG.11 is a graph showing a current (I)-voltage (V) characteristic of the test sample 2A (NH₃+CH₄ gas plasma process) according to the second embodiment of the present invention after the annealing; and
FIGS.12A to 12E are sectional views showing a semiconductor device manufacturing method according to a third embodiment of the present invention.

### DESCRIPTION OF THE PREFERRED EMBODIMENTS

Embodiments of the present invention will be explained with reference to the accompanying drawings hereinafter.

### (Explanation of the semiconductor manufacturing equipment employed in the semiconductor device manufacturing method according to embodiments)

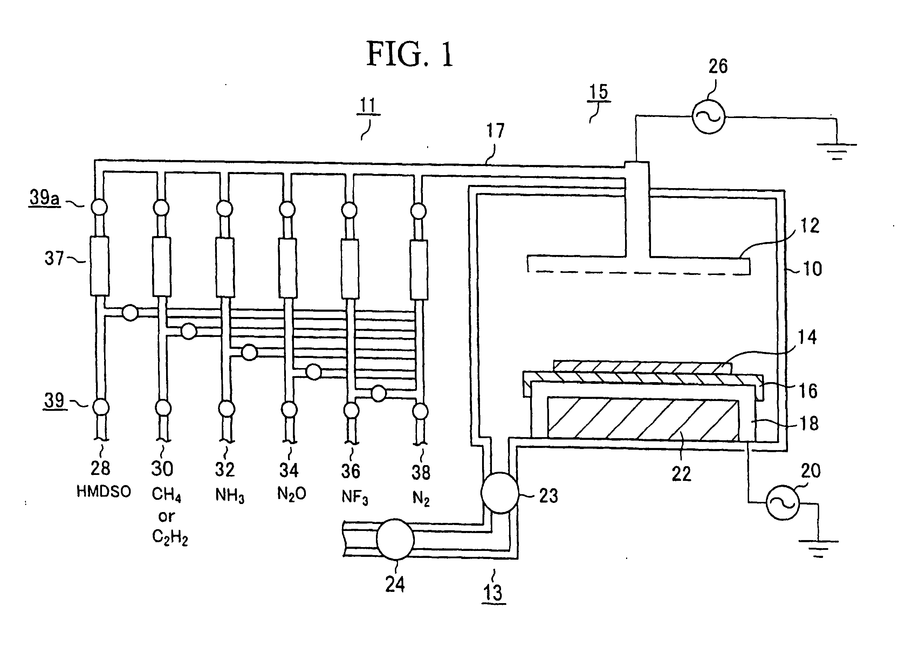

FIG.1 is a schematic sectional view showing the plasma CVD equipment employed in the embodiments of the present invention.

The semiconductor manufacturing equipment employed in the semiconductor device manufacturing method according to embodiments is the plasma CVD (Chemical Vapor Deposition) equipment 15. As shown in FIG.1, this equipment 15 comprises basically a chamber 10 in which the film formation and the plasma process are applied onto a semiconductor substrate, a gas supply system 11 for supplying the gases to the chamber 10, and a gas exhaust system 13 for reducing the pressure in the chamber 10. Two electrodes, i.e., a lower electrode 18 and an upper electrode 12 are provided in the chamber 10. A heater 22 for heating a semiconductor substrate 14 is arranged under the lower electrode 18. Also, a cylindrical susceptor 16 on which the semiconductor substrate 14 is loaded is arranged on an upper portion and a side portion of the lower electrode 18.

A high-frequency power supply 20 of 380 kHz as LF (Low Frequency) is connected to the lower electrode 18, while a high-frequency power supply 26 of 13.56 MHz as RF (Radio Frequency) is connected to the upper electrode 12. If the high-frequency power is supplied to the gas in the chamber 10 by using any one or both of these high-frequency power supplies 20, 26, the gas can be plasmanized.

The upper electrode 12 is also used as the shower head to supply the gas into the chamber 10. A gas supply pipe 17 is connected to this shower head. A HMDSO ((Si(CH₃)₃)₂O) gas line 28, a CH₄ or C₂H₂ gas line 30, an NH₃ gas line 32, an N₂O gas line 34 , an NF₃ gas line 36, and an N₂ gas line 38 are connected to the gas supply pipe 17. Then, a massflow meter 37 and gas supply valves 39 , 39a are provided in these gas lines 28, 30, 32, 34, 36, 38 respectively.

The N₂ gas line 38 is connected to the massflow meter 37 and the gas supply valve 39 provided in the remaining gas lines 28, 30, 32, 34, 36 via a gas valve respectively. Accordingly, the N₂ gas can be supplied to the remaining gas lines 28, 30, 32, 34, 36 as the purge gas.

The above gas lines are shown merely as an example. It is of course that such gas lines can be appropriately varied to supply a desired gas.

An exhaust valve 23 and an exhaust pump 24 are provided in the gas exhaust system 13 connected to the chamber 10.

The plasma CVD equipment 15 employed in the present embodiment is constructed in this manner. First, while reducing the pressure in the chamber 10 by the gas exhaust system 13, the predetermined gas is supplied from the gas supply pipe 17 to the chamber 10 to set the inside of the chamber 10 at a predetermined pressure. Then, the gas is plasmanized by applying the high-frequency voltage to the lower electrode 18 and the upper electrode 12. Because the gas is plasmanized in this manner, the film formation of various films and the plasma process can be applied to the semiconductor substrate. Also, it is of course that the semiconductor substrate can be processed in the gas atmosphere not to plasmanize the gas.

### (Semiconductor device manufacturing method of the present embodiments)

### 1. First embodiment

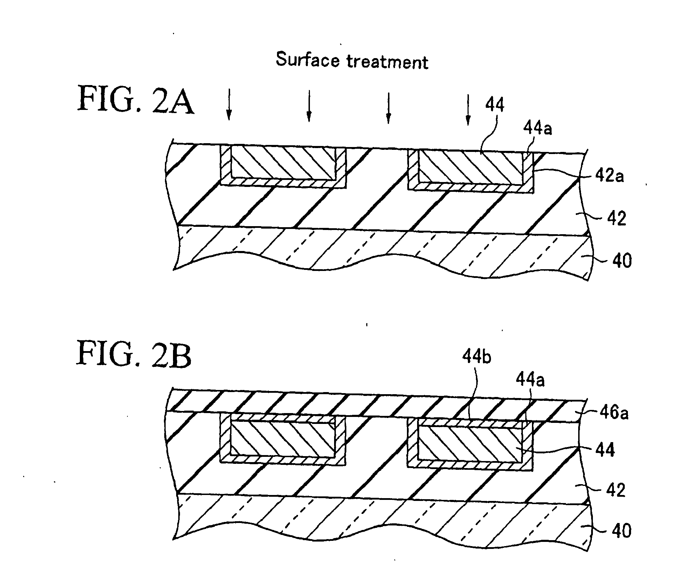

FIGS.2A and 2B are schematic sectional views showing a semiconductor device manufacturing method according to a first embodiment of the present invention.

In the semiconductor device manufacturing method according to the first embodiment of the present invention, first a semiconductor substrate 40 shown in FIG.2A is prepared. That is, predetermined semiconductor elements (not shown) are formed on the semiconductor substrate 40, and Cu (copper) wiring layers 44 each buried in a wiring recess 42a in an insulating film 42 are formed over the semiconductor substrate 40 such that the semiconductor elements are connected electrically to the Cu wiring layers 44.

The Cu wiring layer 44 is buried in the wiring recess 42a via a barrier metal layer 44a made of a TiN layer, a TaN layer, or the like, for example. The barrier metal layer 44a and the Cu wiring layer 44 are buried in the wiring recess 42a by removing the films, which are formed in the wiring recess 42a and on the insulating film 42, from the surface by virtue of the chemical mechanical polishing (CMP) method. After the film of the Cu wiring layer 44 is formed or the Cu wiring layer 44 is buried by the CMP method, the annealing process is applied to this Cu wiring layer 44 in the nonoxidizing gas (e.g., hydrogen gas) atmosphere.

Then, the semiconductor substrate 40 is carried into the chamber 10 of the above plasma CVD equipment 15. Then, a surface of the Cu wiring layer 44 on the semiconductor substrate 40 is exposed to the plasma of the NH₃ (ammonia) gas, the plasma of the mixed gas consisting of N₂ (nitrogen) and H₂ (hydrogen), the plasma of the CF₄ gas, the plasma of the C₂F₆ gas , or the plasma of the NF₃ gas. The natural oxide film formed on a surface layer portion of the Cu wiring layer 44 is removed by this step.

Then, the surface of the Cu wiring layer 44 is exposed to the atmosphere or the plasma of the gas containing the NH₃ (ammonia) gas, the CₓH_{y} gas (hydrocarbon gas), or the like, for example, in the same chamber 10 or another chamber of the same equipment. Accordingly, as shown in FIG.2B, a compound layer (or a bonding layer) 44b is formed on the surface layer portion of the Cu wiring layer 44 because the element such as N, H, C, or the like in the above gas is combined with or bonded to Cu in the surface layer portion of the Cu wiring layer 44.

As a particular example of the gas employed in this step, there is the NH₃ (ammonia) gas, an ethylenediamine gas, a β-diketone gas, a mixed gas of the NH₃ (ammonia) gas and the CₓH_{y} gas (hydrocarbon gas), a mixed gas of the N₂ (nitrogen) and the CₓH_{y} gas (hydrocarbon gas), or the like. In this case, as the CₓH_{y} gas, any one of CH₄ (methane), C₂H₂ (acetylene), C₂H₄ (ethylene), C₃H₈ (propane), C₄H₈ (butylene) , C₄H₁₀ (butane), C₆H₆ (benzene), C₆H₁₂ (cyclohexane) and C₇H₁₄ (methylcyclohexane) may be employed.

If the ethylenediamine gas, the β-diketone gas, the gas of the compound that is similar to them, or the like among these gases is employed, the complex is formed on the surface layer portion of the Cu wiring layer 44. As an example of the β -diketone gas, hexafluoroacetylacetone (C₅H₂O₂F₆) may be employed.

Then, a Cu diffusion preventing insulating film 46 made of a silicon nitride film, or the like is formed on the Cu wiring layer 44, which is subjected to the surface treatment, by the plasma CVD method. At this time, since the compound layer 44b is formed on the surface layer portion of the Cu wiring layer 44, the generation of Cu projections from the surface layer portion of the Cu wiring layer 44 can be suppressed. Accordingly, even if a film thickness of the Cu diffusion preventing insulating film 46 is reduced, the Cu diffusion can be prevented.

Also, in the later step in which the annealing process is applied, the compound layer 44b formed on the surface layer portion of the Cu wiring layer 44 can suppress the generation of the projections from the surface layer portion of the Cu wiring layer 44.

In addition, the compound layer 44b formed on the surface layer portion of the Cu wiring layer 44 can also function as the Cu diffusion preventing film. Therefore, even if the insulating film whose dielectric constant is low but whose Cu diffusion preventing capability is not high, e.g., the silicon-containing insulating film whose dielectric constant is about 4, is employed as the Cu diffusion preventing insulating film, the Cu diffusion can be prevented.

As a result, since the increase in the capacitance between the Cu wiring layers 44 can be prevented, the multi-layered wiring for the high-performance LSI having the small wiring delay can be manufactured.

### (1) First example

Then, a first example of the semiconductor device manufacturing method according to the first embodiment of the present invention will be shown hereunder. First, the surface treatment of the Cu wiring layers 44 on the semiconductor substrate 40 is carried out under two-step conditions, described in the following, by using the above plasma CVD equipment 15.

### (First step)

| | |
|---|---|
| NH₃ flow rate | 500 sccm |
| Pressure | 1 Torr |
| Temperature of the susceptor 16 (semiconductor substrate 40) | 375°C |
| Power of the high-frequency power supply 26 of 13.56 MHz | 100 W |
| Process time | 10 second |

In the first step, the natural oxide film formed on the surface layer portion of the Cu wiring layer 44 is removed.

### (Second step)

| | |
|---|---|
| NH₃ flow rate | 500 sccm |
| Pressure | 1 Torr |
| Process time | 60 second |

Then, the silicon-containing insulating film 46 (Cu diffusion preventing insulating film) of 100 nm thickness is formed in the same chamber of the plasma CVD equipment 15 or another chamber under following film forming conditions, as an example.

| | |
|---|---|
| HMDSO flow rate | 50 sccm |
| N₂O flow rate | 100 sccm |
| NH₃ flow rate | 200 sccm |
| Pressure | 1 Torr |
| Power of the high-frequency power supply 20 of 380 kHz | 150 W |

### (2) Second example

Then, a second example of the semiconductor device manufacturing method according to the first embodiment will be shown hereunder. First, the surface treatment of the Cu wiring layers 44 on the semiconductor substrate 40 is carried out under two-step conditions, described in the following, by using the above plasma CVD equipment 15.

### (First step)

The natural oxide film formed on the surface layer portion of the Cu wiring layer 44 is removed by executing the process under the same conditions as the first example.

### (Second step)

| | |
|---|---|
| NH₃ flow rate | 200 sccm |
| CH₄ flow rate | 200 sccm |
| Pressure | 1 Torr |
| Power of the high-frequency power supply 26 of 13.56 MHz | 100 W |
| Process time | 30 second |

Then, the silicon-containing insulating film 46 (Cu diffusion preventing insulating film) of 100 nm thickness is formed by the same method as the first example.

### (3) Third example

Then, a third example of the semiconductor device manufacturing method according to the first embodiment will be shown hereunder. First, the surface treatment of the Cu wiring layers 44 on the semiconductor substrate 40 is carried out under two-step conditions, described in the following, by using the above plasma CVD equipment 15.

### (First step)

The natural oxide film formed on the surface layer portion of the Cu wiring layer 44 is removed by executing the process under the same conditions as the first example.

### (Second step)

| | |
|---|---|
| Ethylenediamine flow rate | 200 sccm |
| Pressure | 1 Torr |
| Process time | 60 second |

Then, the silicon-containing insulating film 46 (Cu diffusion preventing insulating film) of 100 nm thickness is formed by the same method as the first example.

### (4) Fourth example

Then, a fourth example of the semiconductor device manufacturing method according to the first embodiment will be shown hereunder. First, the surface treatment of the Cu wiring layers 44 on the semiconductor substrate 40 is carried out under two-step conditions, described in the following, by using the above plasma CVD equipment 15.

### (First step)

The natural oxide film formed on the surface layer portion of the Cu wiring layer 44 is removed by executing the process under the same conditions as the first example.

### (Second step)

| | |
|---|---|
| Ethylenediamine flow rate | 200 sccm |
| Pressure | 1 Torr |
| Power of the high-frequency power supply 26 of 13.56 MHz | 100 W |
| Process time | 30 second |

Then, the silicon-containing insulating film 46 (Cu diffusion preventing insulating film) of 100 nm thickness is formed by the same method as the first example.

### (5) Fifth example

Then, a fifth example of the semiconductor device manufacturing method according to the first embodiment will be shown hereunder. First, the surface treatment of the Cu wiring layers 44 on the semiconductor substrate 40 is carried out under two-step conditions, described in the following, by using the above plasma CVD equipment 15.

### (First step)

The natural oxide film formed on the surface layer portion of the Cu wiring layer 44 is removed by executing the process under the same conditions as the first example.

### (Second step)

| | |
|---|---|
| Ethylenediamine flow rate | 200 sccm |
| Pressure | 1 Torr |
| Power of the high-frequency power supply 26 of 13.56 MHz | 100 W |
| Process time | 30 second |

Then, the silicon-containing insulating film 46 (Cu diffusion preventing insulating film) of 100 nm thickness is formed by the same method as the first example.

### (Post-process)

Then, as the post-process, the surface treatment of the silicon-containing insulating film 46 (Cu diffusion preventing insulating film) is carried out under following conditions.

| | |
|---|---|
| Ethylenediamine flow rate | 200 sccm |
| Pressure | 1 Torr |
| Process time | 60 second |

### (6) Sixth example

Then, a sixth example of the semiconductor device manufacturing method according to the first embodiment will be shown hereunder. First, the surface treatment of the Cu wiring layers 44 on the semiconductor substrate 40 is carried out under two-step conditions, described in the following, by using the above plasma CVD equipment 15.

### (First step)

The natural oxide film formed on the surface layer portion of the Cu wiring layer 44 is removed by executing the process under the same conditions as the first example.

### (Second step)

| | |
|---|---|
| Ethylenediamine flow rate | 200 sccm |
| Pressure | 1 Torr |
| Power of the high-frequency power supply 26 of 13.56 MHz | 100 W |
| Process time | 30 second |

Then, the silicon-containing insulating film 46 (Cu diffusion preventing insulating film) of 100 nm thickness, for example, is formed by the same method as the first example.

### (Post-process)

| | |
|---|---|
| Ethylenediamine flow rate | 200 sccm |
| Pressure | 1 Torr |
| Power of the high-frequency power supply 26 of 13.56 MHz | 100 W |
| Process time | 60 second |

Then, as the post-process, the surface treatment of the silicon-containing insulating film 46 (Cu diffusion preventing insulating film) is carried out under following conditions.

Like the fifth example and the sixth example, if the surface of the silicon-containing insulating film 46 is exposed to the atmosphere or the plasma of the ethylenediamine gas after such silicon-containing insulating film 46 is formed, the Cu diffusion can be prevented much more.

### (Test made by the inventors of this application)

The inventors of this application checked the effects of the above semiconductor device manufacturing method according to the first embodiment.

### (1) Formation of the reference sample

First, in order to check the effects of the above semiconductor device manufacturing method according to the present embodiment, the reference sample is formed. More particularly, while applying no process to the surface of the Cu wiring layer 44 on the semiconductor substrate 40, the silicon-containing insulating film 46 (Cu diffusion preventing insulating film) is formed on the Cu wiring layer 44. As the silicon-containing insulating film 46, there is employed the film that has the film characteristic, whose Cu-diffusion preventing capability is low such that the Cu in the Cu wiring layer 44 is readily diffused when this film is annealed at 450 °C for four hours, for example. As the film forming conditions, the conditions using the HMDSO only as the gas are employed, as described in the following, among the film forming conditions of the Cu diffusion preventing insulating film in the first example.

| | |
|---|---|
| HMDSO flow rate | 50 sccm |
| Pressure | 1 Torr |
| Power of the high-frequency power supply 20 of 380 kHz | 150 W |

### (2) Formation of the test sample

Then, the test sample is formed by the following method.

First, the natural oxide film on the surface layer portion is removed by exposing the surface of the Cu wiring layer 44 on the semiconductor substrate 40 to the NH₃ plasma while using the above plasma CVD equipment 15. Then, the surface treatment of the Cu wiring layer 44 is carried out by the RF plasma (the pressure: 2.0 Torr) of the mixed gas consisting of the NH₃ gas and C₇H₁₄ (methylcyclohexane). Then, the silicon-containing insulating film 46 is formed on the Cu wiring layer 44 under the conditions identical to the film forming conditions of the above reference sample.

### (3) Test method and test results

First, with regard to the reference sample and the test sample, the current (I)-voltage (V) characteristic of the silicon-containing insulating film 46 (Cu diffusion preventing insulating film) was checked by the Hg-probe method respectively. Then, after the reference sample and the test sample were annealed at 450 °C for four hours, the current (I)-voltage (V) characteristic of the silicon- containing insulating film 46 was checked once again by the Hg-probe method respectively.

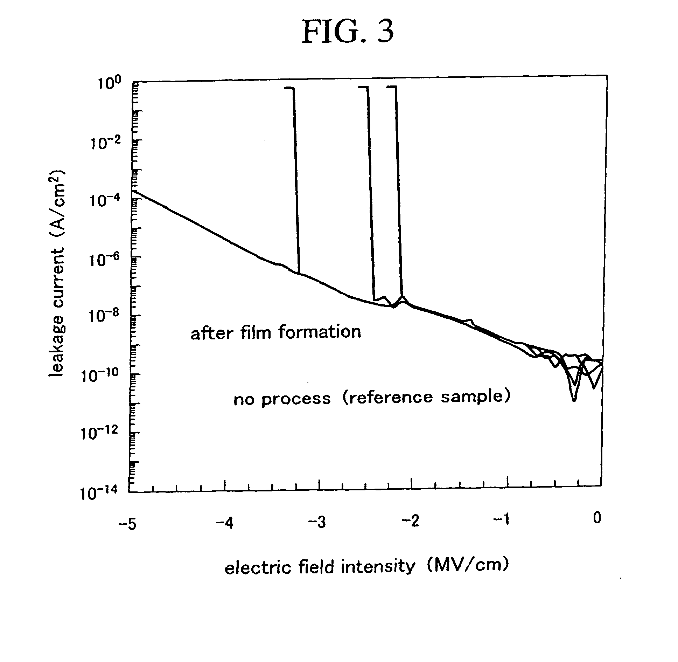

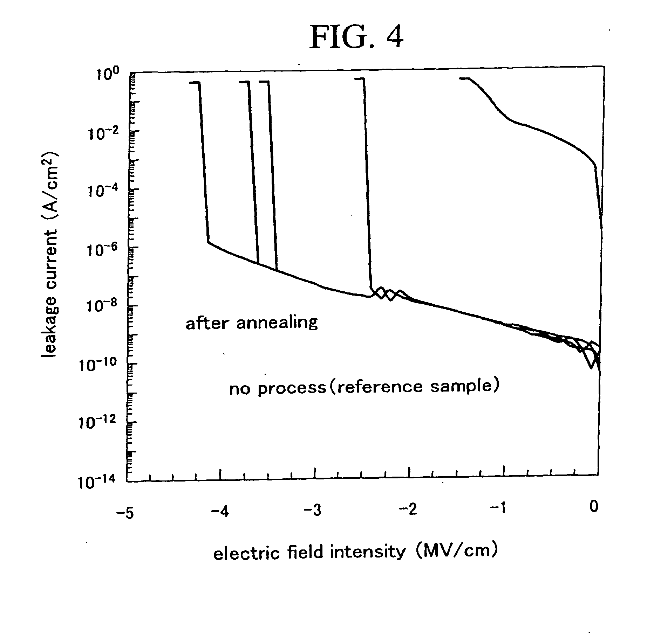

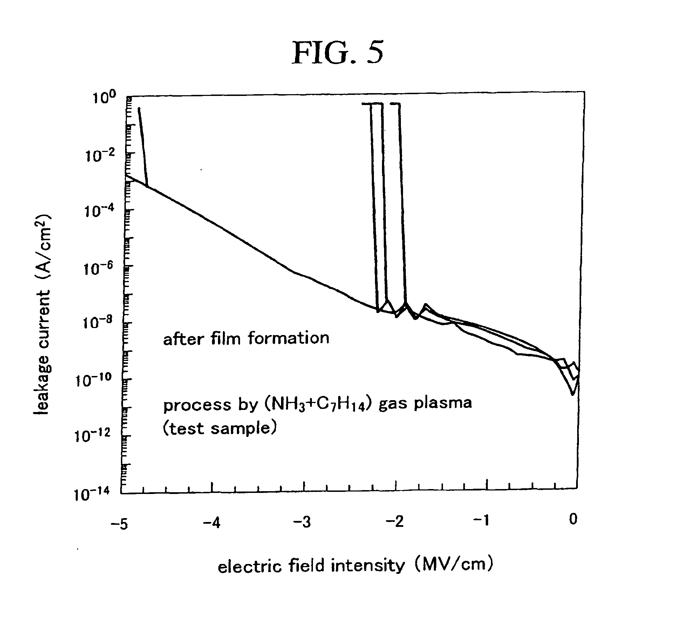

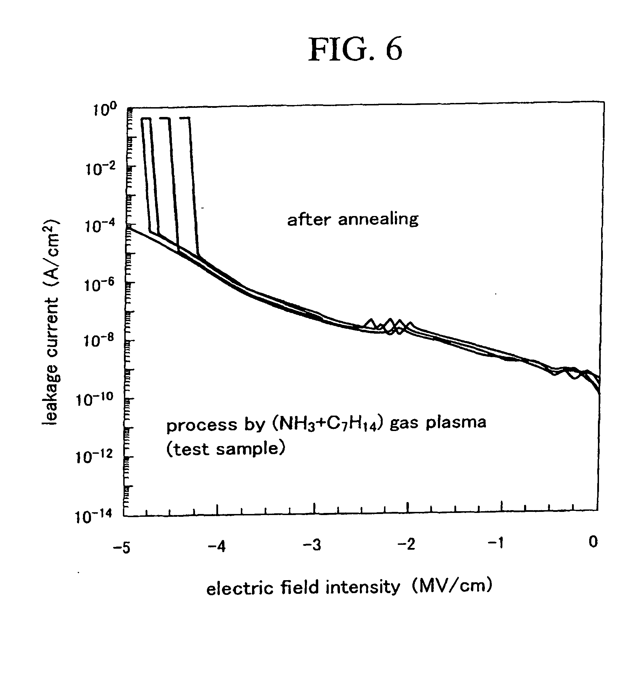

FIG.3 shows a current (I)-voltage (V) characteristic of the reference sample prior to the annealing, FIG.4 shows a current (I)-voltage (V) characteristic of the reference sample after the annealing, FIG.5 shows a current (I)-voltage (V) characteristic of the test sample prior to the annealing, and FIG.6 shows a current (I)-voltage (V) characteristic of the test sample after the annealing. An abscissa of these graphs denotes the electric field intensity (MV/cm) and an ordinate of them denotes the leakage current (A/cm2) .

According to the I-V characteristic after the silicon- containing insulating film 46 of the reference sample (prior to the annealing), as shown in FIG.3, the film had a predetermined dielectric breakdown voltage although such voltage is slightly varied according to locations in the semiconductor substrate. Then, when the reference sample was annealed at 450 °C for four hours, much leakage current was flown through the silicon-containing insulating film 46 at the low electric field intensity according to the locations in the semiconductor substrate, as apparent from the comparison between FIG.3 and FIG.4. Thus, it was validated that there is such a tendency that the dielectric breakdown voltage is lowered by the annealing.

In other words, this means that, if the predetermined process is not applied to the surface of the Cu wiring layer 44 unlike the present embodiment, the Cu in the Cu wiring layer 44 can be readily diffused into the Cu diffusion preventing insulating film 46 (silicon-containing insulating film) whose Cu diffusion preventing capability was lowered by the annealing.

In the test sample, the surface of the Cu wiring layer 44 was subjected to the RF plasma process (13.56 MHz) by using the mixed gas consisting of NH₃ gas +C₇H₁₄ (methylcyclohexane) gas. As apparent from the comparison between FIG.5 and FIG.6, no reduction in the dielectric breakdown voltage of the silicon-containing insulating film 46 appeared even if the annealing was applied. Thus, it was validated that such dielectric breakdown voltage is equivalent to or more than that obtained prior to the annealing.

As described above, it was checked that, if the surface treatment of the Cu wiring layer 44 is carried out by using the semiconductor device manufacturing method according to the present embodiment, the dielectric breakdown voltage of the silicon-containing insulating film 46 (Cu diffusion preventing insulating film) on the Cu wiring layer 44 after the annealing is equivalent or more than the voltage obtained before the annealing based on the current (I)-voltage (V) characteristic, and thus the diffusion of Cu in the Cu wiring layer 44 into the silicon-containing insulating film 46 can be prevented.

### 2. Second embodiment

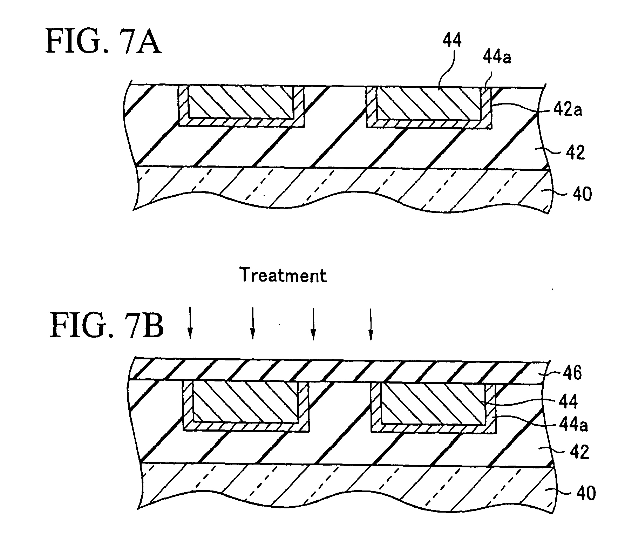

FIGS.7A and 7B are schematic sectional views showing a semiconductor device manufacturing method according to a second embodiment of the present invention. In the semiconductor device manufacturing method according to the second embodiment, since the natural oxide film formed on the surface layer portion of the Cu wiring layer is removed, then the silicon-containing insulating film whose dielectric constant is relatively low is formed on the Cu wiring layer, and then the predetermined process is applied to this silicon-containing insulating film, the film quality of the silicon-containing insulating film can be changed into the Cu diffusion preventing insulating film, whose Cu diffusion preventing capability is high, to prevent the diffusion of Cu.

In the semiconductor device manufacturing method according to the second embodiment, first the semiconductor substrate 40 having the Cu wiring layer 44, as shown in FIG.7A, like the first embodiment, is prepared.

Then, the semiconductor substrate 40 is carried into the chamber 10 of the above plasma CVD equipment, and then the natural oxide film formed on the surface layer portion of the Cu wiring layer 44 is removed by exposing the surface of the Cu wiring layer 44 on the semiconductor substrate 40 to the plasma of the NH₃ (ammonia) gas.

Then, as shown in FIG.7B, a silicon-containing insulating film 46a is formed on the Cu wiring layer 44, from the surface of which the natural oxide film is removed, in the same chamber 10 or another chamber of the same equipment. At this time, if the silicon-containing insulating film 46a is formed by using the reaction gas containing HMDSO, or the like, the film whose dielectric constant is about 3.5 to 4 can be formed. In this case, this silicon-containing insulating film 46a is the insulating film whose Cu diffusion preventing capability is not so high. As the silicon-containing insulating film 46a, the silicon nitride film, the silicon oxide film, the silicon oxide nitride film, etc. may be employed.

Then, the silicon-containing insulating film 46a is exposed to the atmosphere or the plasma of the mixed gas consisting of the NH₃ (ammonia) gas and the CₓH_{y} (hydrocarbon) gas, the atmosphere or the plasma of the mixed gas consisting of the N₂ (nitrogen) gas and the CₓH_{y} (hydrocarbon) gas, the plasma of the N₂ (nitrogen) gas, or the atmosphere of the NH₃ (ammonia) gas in the same chamber 10 or another chamber of the same equipment.

As the plasma of the mixed gas consisting of the NH₃ gas and the CₓH_{y} gas, the plasma of the mixed gas consisting of the N₂ gas and the CₓH_{y} gas, and the plasma of the N₂ gas, it is preferable that the RF plasma of 13.56 MHz or the LF plasma of 380 kHz should be employed.

In this step, the process may be carried out by two steps described in the following. More particularly, first the silicon-containing insulating film 46 may be exposed to either the atmosphere or the plasma of the NH₃ gas or the plasma of the N₂ gas, and then such film may be exposed to the atmosphere or the plasma of the CₓH_{y} gas. Otherwise, in the opposite sequence to the above two steps, first the silicon-containing insulating film 46 may be exposed to the atmosphere or the plasma of the CₓH_{y} gas, and then such film may be exposed to either the atmosphere or the plasma of the NH₃ gas or the plasma of the N₂ gas.

In this case, the same gas as that explained in the first embodiment can be employed as the CₓH_{y} gas.

In this manner, the film quality of the silicon-containing insulating film 46a is changed by processing the silicon-containing insulating film 46 using the above gas, and thus this film 46a can function as the Cu diffusion preventing insulating film for preventing the diffusion of Cu. In other words, the silicon-containing insulating film 46a which has the low dielectric constant can be employed as the Cu diffusion preventing insulating film that can prevent the diffusion of Cu. Accordingly, since the increase in the parasitic capacitance around the Cu wiring of the multi-layered wiring, the multi-layered wiring for the high-performance LSI having the small wiring delay can be manufactured.

Also, since the natural oxide film on the surface layer portion of the Cu wiring layer 44 is removed by the plasma of the NH₃ gas and then the silicon-containing insulating film 46a is formed on the Cu wiring layer 44, the adhesiveness between the Cu wiring layer 44 and the silicon-containing insulating film 46a can be improved. Therefore, the reliability of the multi-layered wiring can be improved.

### (1) First example (not covered by the invention)

A first example of the semiconductor device manufacturing method according to the second embodiment will be shown hereunder. First, the semiconductor substrate 40 is carried in the chamber 10 of the above plasma CVD equipment, and then the natural oxide film on the surface layer portion of the Cu wiring layer 44 is removed under the conditions described in the following.

| | |
|---|---|
| NH₃ flow rate | 500 sccm |
| Pressure | 1 Torr |
| Temperature of the susceptor 16 (semiconductor substrate 40) | 375°C |
| Power of the high-frequency power supply 26 of 13.56 MHz | 100 W |
| Process time | 10 second |

In turn, the silicon-containing insulating film 46a of 100 nm thickness, for example, is formed under following film forming conditions, as an example, in the same chamber 10 or another chamber.

| | |
|---|---|
| HMDSO flow rate | 50 sccm |
| N₂O flow rate | 100 sccm |
| NH₃ flow rate | 200 sccm |
| Pressure | 1 Torr |
| Power of the high-frequency power supply 20 of 380 kHz | 150 W |

Subsequently, the silicon-containing insulating film 46a is processed under following conditions.

| | |
|---|---|
| NH₃ flow rate | 200 sccm |
| Pressure | 1 Torr |
| Power of the high-frequency power supply 26of 380 kHz | 150 W |
| Process time | 60 second |

### (2) Second example (not covered by the invention)

Then, a second example of the semiconductor device manufacturing method according to the second embodiment will be shown hereunder. First, the natural oxide film on the surface layer portion of the Cu wiring layer 44 is removed by the same method as the first example. Then, the silicon-containing insulating film 46a of 100 nm thickness is formed.

Then, this silicon-containing insulating film 46a is processed under following conditions.

| | |
|---|---|
| NH₃ flow rate | 200 sccm |
| Pressure | 1 Torr |
| Power of the high-frequency power supply 20 of 380 kHz | 100 W |
| Process time | 60 second |

### (3) Third example (not covered by the invention)

A third example of the semiconductor device manufacturing method according to the second embodiment will be shown hereunder. First, the natural oxide film on the surface layer portion of the Cu wiring layer 44 is removed by the same method as the first example, and then the silicon-containing insulating film 46a is formed to have a thickness of 100 nm.

Then, the silicon-containing insulating film 46a is processed under following conditions.

| | |
|---|---|
| NH₃ flow rate | 200 sccm |
| CH₄ flow rate | 200 sccm |
| Pressure | 1 Torr |
| Power of the high-frequency power supply 26 of 380 kHz | 100 W |
| Process time | 60 second |

### (4) Fourth example

A fourth example of the semiconductor device manufacturing method according to the second embodiment will be shown hereunder. First, the natural oxide film on the surface layer portion of the Cu wiring layer 44 is removed by the same method as the first example, and then the silicon-containing insulating film 46a is formed to have a thickness of 100 nm.

Then, the silicon-containing insulating film 46a is processed by two steps described in the following.

### (First step)

| | |
|---|---|
| NH₃ flow rate | 500 sccm |
| Pressure | 1 Torr |
| Power of the high-frequency power supply 26 of 380 kHz | 100 W |
| Process time | 30 second |

### (Second step)

| | |
|---|---|
| CH₄ flow rate | 500 sccm |
| Pressure | 1 Torr |
| Power of the high-frequency power supply 26 of 380 kHz | 100 W |
| Process time | 30 second |

### (Test made by the inventors of this application)

The inventors of this application formed test samples 1A. 2A on the basis of the manufacturing method in the first example and the fourth example according to the second embodiment respectively, and then checked the current (I)-voltage (V) characteristic of the silicon-containing insulating film 46a by the same method as that in the test of the first embodiment.

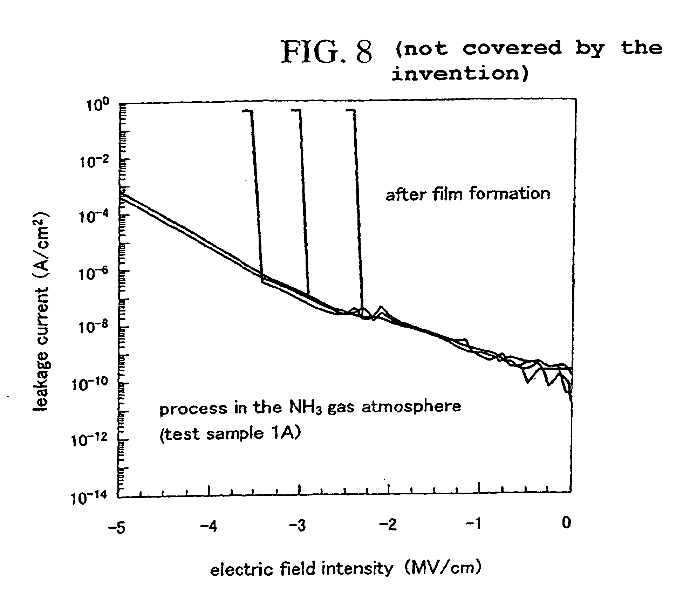

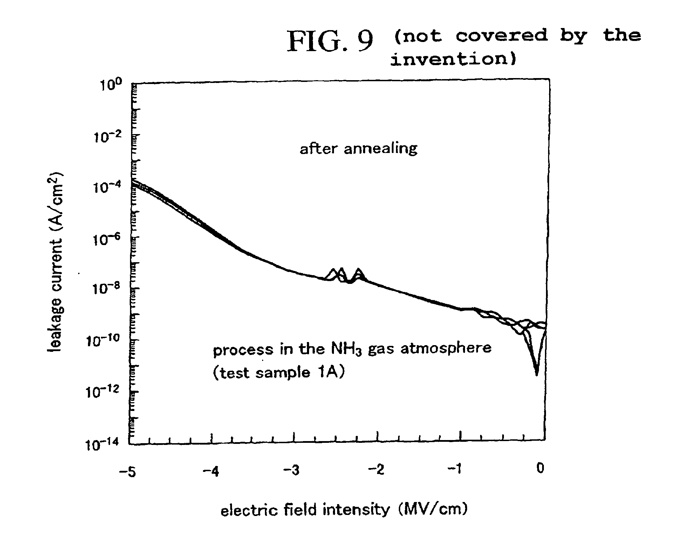

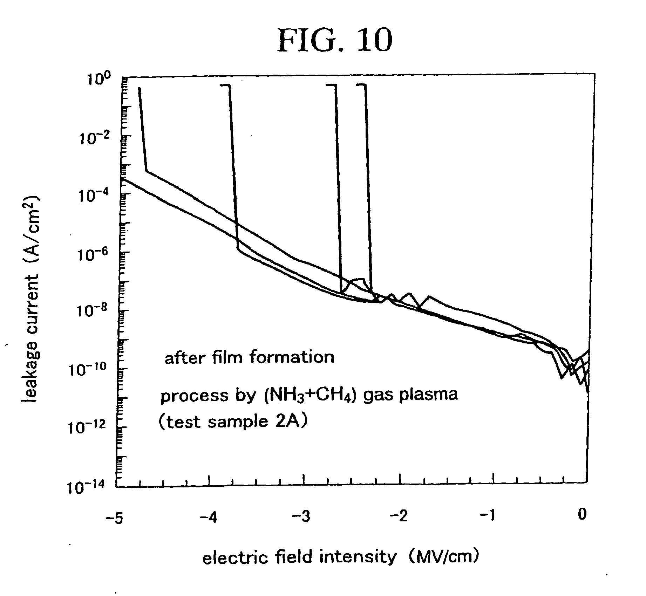

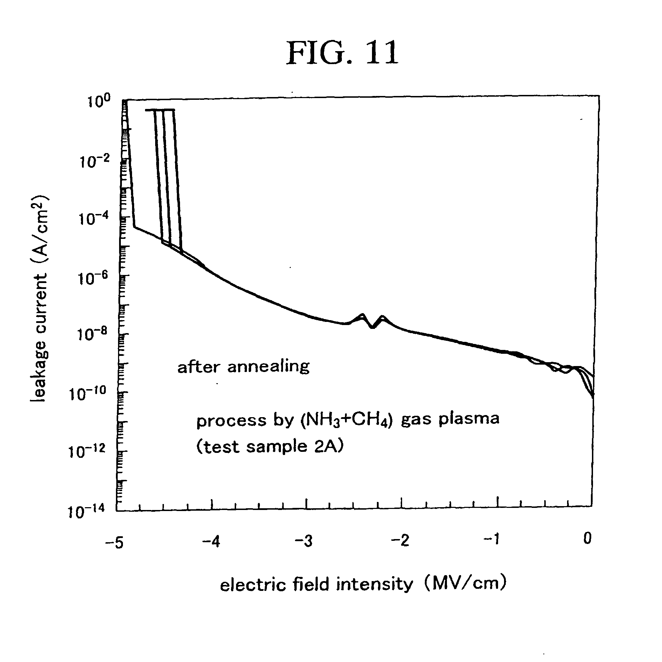

FIG.8 shows a current (I)-voltage (V) characteristic of a test sample 1A prior to the annealing, FIG.9 shows a current (I)-voltage (V) characteristic of the test sample 1A after the annealing, FIG.10 shows a current (I)-voltage (V) characteristic of a test sample 2A prior to the annealing, and FIG.11 shows a current (I)-voltage (V) characteristic of the test sample 2A after the annealing.

According to the current (I)-voltage (V) characteristic of the silicon-containing insulating film 46a of the test sample 1A (the silicon-containing insulating film 46a is processed in the NH₃ gas atmosphere (pressure: 0.5 Torr)), as apparent from the comparison between FIG.8 and FIG.9, the deterioration of the dielectric breakdown voltage of the silicon-containing insulating film 46a did not appear even after the annealing was carried out. Thus, it was confirmed that the dielectric breakdown voltage is equivalent to or more than that obtained prior to the annealing.

Also, in the current (I)-voltage (V) characteristic of the silicon-containing insulating film 46a of the test sample 2A (the silicon-containing insulating film 46a is processed by using the mixed gas consisting of the NH₃ gas and the CH₄ gas (pressure: 4 Torr)), as apparent from the comparison between FIG.10 and FIG.11, no deterioration of the dielectric breakdown voltage of the silicon-containing insulating film 46a appeared even after the annealing was carried out. Thus, it was confirmed that the dielectric breakdown voltage is equivalent to or more than that obtained prior to the annealing.

These test results mean that the silicon-containing insulating film 46a can prevent the diffusion of Cu from the Cu wiring layer 44. In this manner, it was confirmed that, if the silicon-containing insulating film 46a is exposed to the NH₃ gas atmosphere or is processed by the plasma of the mixed gas consisting of the NH₃ gas and the CH₄ gas by using the manufacturing method in the second embodiment, the silicon-containing insulating film 46a can get the high Cu diffusion preventing function.

### 3. Third embodiment

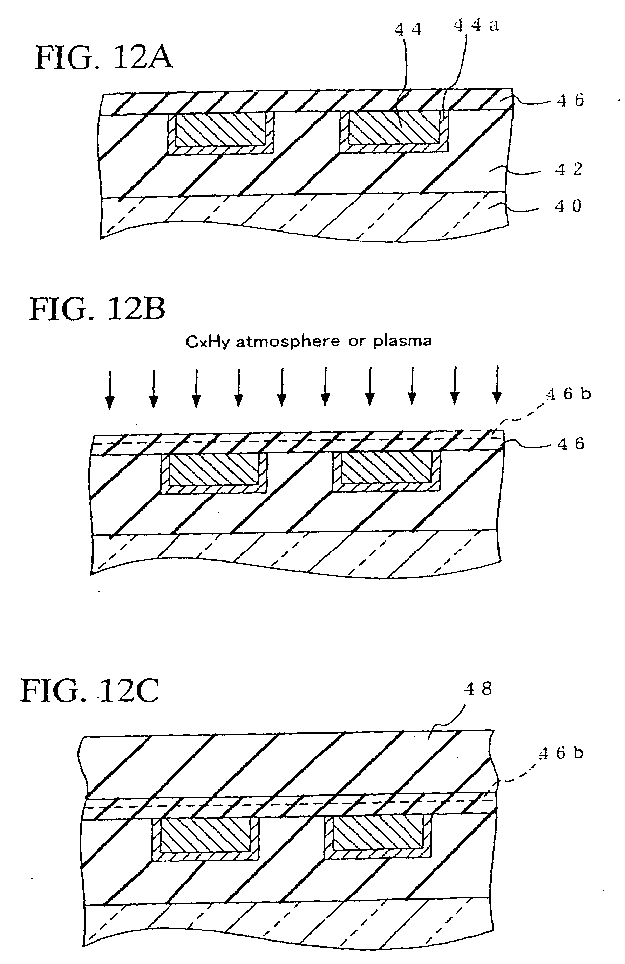

In the above second embodiment, two-step process consisting of the ammonia process and the CₓH_{y} process is applied to the silicon-containing insulating film 46 on the copper wiring layer 44. As the case may be, as shown in FIG.12B, one-step process in which the silicon-containing insulating film 46 on the copper wiring layer 44 is exposed to the atmosphere or the plasma of the hydrocarbon (CₓH_{y}) gas may be carried out.

For instance, a carbon-containing layer 46b of about 5 nm thickness is formed by executing the process under following conditions.

| | |
|---|---|
| C₂H₂ flow rate | 50 sccm |
| Pressure | 0.5 Torr |
| Power of the high-frequency power supply 26 of 380 kHz | 0 W |
| Power of the high-frequency power supply 20 of 380 kHz | 150 W |
| Substrate temperature | 375°C |

This carbon-containing layer 46b has the barrier property against the copper particle of the copper wiring layer 44 and has the sufficient etching resistance against the gaseous or liquid etchant for the silicon-containing insulating film.

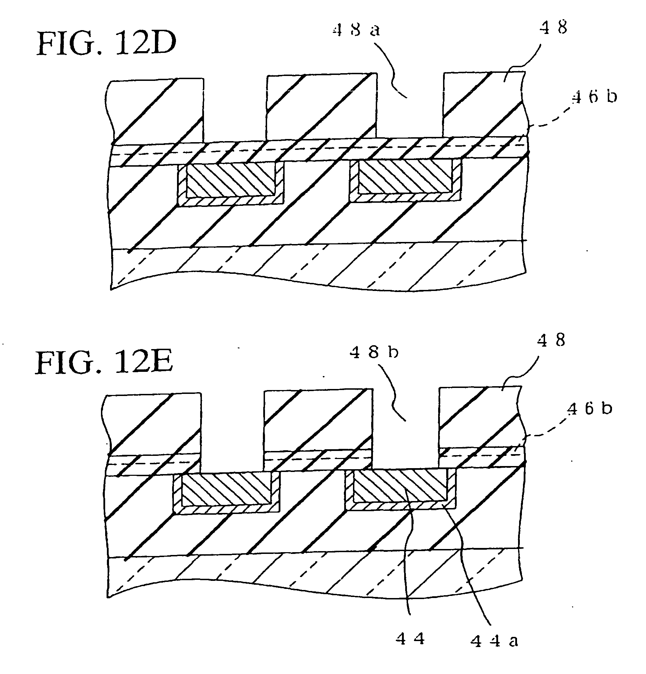

Accordingly, not only the barrier function against the copper particles of the Cu wiring layer 44 but also the etching stopper function used when opening portions 48a are formed by etching the thick interlayer insulating film 48 formed on the silicon-containing insulating film 46, as shown in FIG.12D, can be provided to the silicon-containing insulating film 46 by the simple process.

In this case, as the hydrocarbon (CₓH_{y}) gas, the compound set forth in the first embodiment may be employed in addition to C₂H₂.

Examples to which the process is applied will be explained with reference to FIGS.12A to 12C and FIG.12D and 13B hereunder.

FIGS.12A to 12E are sectional views showing a semiconductor device manufacturing method according to the third embodiment. The silicon-containing insulating film 46 serving as the barrier insulating film is formed on the buried Cu wiring layer 44 in the same manner as the second embodiment until the surface treatment in FIG.7B is applied. This state is shown in FIG.12A. Then, as shown in FIG.12B, the surface treatment is carried out under the above conditions by using the atmosphere or the plasma of the hydrocarbon (CₓH_{y}) gas. Then, as shown in FIG.12C, the interlayer insulating film 48 is formed. Then, as shown in FIG.12D, the opening portions 48a are formed by etching the interlayer insulating film 48 while using the carbon-containing layer 46b as the etching stopper to expose the silicon-containing insulating film 46. Then, as shown in FIG.12E opening portions 48b are formed by etching the silicon- containing insulating film 46 via the opening portions 48a to expose the wiring layer being made mainly of the copper film 44 at their bottom portions. Then, the upper wiring layer connected to the wiring layer being made mainly of the copper film 44 via the opening portions 48b, etc. are formed.

In the above, the compound layer 44b shown in FIG.2 is not formed on the surface layer of the copper film 44 before the silicon-containing insulating film 46 is formed. But the compound layer 44b shown in FIG.2 may be formed.

With the above, details of the present invention are explained with reference to the first to third embodiments. But the scope of the present invention is not limited to the examples that are particularly shown in the above embodiments. The variation and the modification of the above embodiments within the range of gist that does not depart from the present invention should be contained in the scope of the present invention.

## Claims

1. A semiconductor device manufacturing method comprising the steps of:
Forming a silicon-containing insulating film (46) on a wiring layer (44) made mainly of copper (Cu) formed over a semiconductor substrate (40); and exposing the silicon-containing insulating film (46) to an atmosphere or a plasma of a hydrocarbon (CxHy) gas.

2. A semiconductor device manufacturing method according to claim 1 further comprising the steps of:
Exposing the surface of the wiring layer (44) made mainly of copper (Cu) to a plasma of an ammonia gas before the silicon-containing insulating film (46) forming step; exposing the silicon-containing insulating film (46) to an atmosphere or a plasma of an ammonia gas or a plasma of nitrogen gas before the step of exposing the silicon-containing insulating film (46) to an atmosphere or a plasma of a hydrocarbon gas (CxHy).

3. A semiconductor device manufacturing method according to claim 1 further comprising the steps of:
Exposing the surface of the wiring layer (44) made mainly of the copper (Cu) to a plasma of an ammonia gas before the silicon-containing insulating film (46) forming step; exposing the silicon-containing insulating film (46) to an atmosphere or a plasma of an ammonia gas or a plasma of a nitrogen gas after the step of exposing the silicon-containing insulating film (46) to the atmosphere or the plasma of said hydrocarbon gas (CxHy).

## Patentansprüche

1. Verfahren zur Herstellung eines Halbleiterbauelements mit den Schritten:
Ausbilden eines Silizium enthaltenden, isolierenden Films (46) auf einer Leitungs- bzw. Verdrahtungsschicht (44), die in der Hauptsache aus Kupfer (Cu) hergestellt ist, das über einem Halbleiter-Substrat (40) ausgebildet ist; und
Aussetzen des Silizium enthaltenden, isolierenden Films (46) einer Atmosphäre oder einem Plasma aus einem Kohlenwasserstoff- (CxHy) Gas.

2. Verfahren zur Herstellung eines Halbleiterbauelements nach Anspruch 1, weiter mit den Schritten:
Aussetzen der Oberfläche der Verdrahtungsschicht (44), die in der Hauptsache aus Kupfer (Cu) hergestellt ist, einem Plasma aus einem Ammoniak-Gas vor dem Schritt der Ausbildung des Silizium enthaltenden, isolierenden Films (46); Aussetzen des Silizium enthaltenden, isolierenden Films (46) einer Atmosphäre oder einem Plasma aus einem Ammoniak-Gas oder einem Plasma aus einem Stickstoff-Gas vor dem Schritt des Aussetzens des Silizium enthaltenden, isolierenden Films (46) einer Atmosphäre oder einem Plasma aus einem Kohlenwasserstoff-Gas (CxHy).

3. Verfahren zur Herstellung eines Halbleiterbauelements nach Anspruch 1, weiterhin mit den Schritten:
Aussetzen der Oberfläche der Verdrahtungsschicht (44), die in der Hauptsache aus Kupfer (Cu) hergestellt ist, einem Plasma aus einem Ammoniak-Gas vor dem Schritt der Ausbildung des Silizium enthaltenden, isolierenden Films (46); Aussetzen des Silizium enthaltenden, isolierenden Films (46) einer Atmosphäre oder einem Plasma aus einem Ammoniakgas oder einem Plasma aus einem Stickstoff-Gas nach dem Schritt des Aussetzens des Silizium enthaltenden, isolierenden Films (46) der Atmosphäre oder dem Plasma aus dem Kohlenwasserstoff-Gas (CxHy).

## Revendications

1. Procédé de fabrication d'un dispositif à semi-conducteurs comportant les étapes consistant à :
former un film isolant contenant du silicium (46) sur une couche de câblage (44) constituée principalement de cuivre (Cu) formée sur un substrat semi-conducteur (40), et exposer le film isolant contenant du silicium (46) à une atmosphère ou un plasma d'un hydrocarbure gazeux (CxHy).

2. Procédé de fabrication d'un dispositif à semi-conducteurs selon la revendication 1, comportant de plus les étapes consistant à :
exposer la surface de la couche de câblage (44) constituée principalement de cuivre (Cu) à un plasma d'ammoniac gazeux avant l'étape de formation du film isolant contenant du silicium (46), exposer le film isolant contenant du silicium (46) à une atmosphère ou un plasma d'ammoniac gazeux ou un plasma d'azote gazeux avant l'étape d'exposition du film isolant contenant du silicium (46) à une atmosphère ou un plasma d'un hydrocarbure gazeux (CxHy).

3. Procédé de fabrication d'un dispositif à semi-conducteurs selon la revendication 1, comportant de plus les étapes consistant à :
exposer la surface de la couche de câblage (44) constituée principalement de cuivre (Cu) à un plasma d'ammoniac gazeux avant l'étape de formation du film isolant contenant du silicium (46), exposer le film isolant contenant du silicium (46) à une atmosphère ou un plasma d'ammoniac gazeux ou un plasma d'azote gazeux après l'étape d'exposition du film isolant contenant du silicium (46) à l'atmosphère ou au plasma dudit hydrocarbure gazeux (CxHy).
